# EUROPEAN PATENT APPLICATION

(11) **EP 4 679 485 A2**
(43) Date of publication of application: **14.01.2026**
(21) Application number: 25182158.3
(22) Date of filing: 11.06.2025
(51) Int. Cl.: H01J 37/26, G06F 8/34, H01J 37/28

(54) **CHARGED PARTICLE BEAM APPARATUS AND IMAGE PRODUCTION METHOD**

(30) Priority: 21.06.2024 JP 2024100407
(71) Applicant: JEOL Ltd., Akishima, Tokyo 196-8558 (JP)
(72) Inventor: NAGOSHI, Tatsuro, Tokyo, 196-8558 (JP); ZAIMOKU, Hisashi, Tokyo, 196-8558 (JP); KONDOU, Takayuki, Tokyo, 196-8558 (JP)
(74) Representative: Boult Wade Tennant LLP

(57) **Abstract**

A composite image (92) includes a flow image (106), and may include an overhead image (102) and a report (108). The overhead image (102) may include a plurality of marks (118) representing a plurality of measurement regions. The flow image (106) includes a plurality of graphics arranged along a main flow direction. Of the plurality of graphics, a multi-graphic includes a plurality of symbols arranged along a sub flow direction. As the report (108), a provisional report or an actual report may be displayed.

## Description

### TECHNICAL FIELD

The present disclosure relates to a charged particle beam apparatus and a method of producing an image, and in particular to a technique for assisting setting or checking of a measurement sequence for sequentially measuring a plurality of measurement regions on a sample.

### BACKGROUND

Known charged particle beam apparatuses include a scanning electron microscope, a transmission electron microscope, an ion beam processing apparatus, and the like. In the following, the scanning electron microscope will be described.

Among scanning electron microscopes there are apparatuses that have a function to sequentially measure a plurality of measurement regions on a sample (multi-point measurement function). When the multi-point measurement function is used, normally, a user sets a plurality of measurement regions on the sample, and sets a measurement sequence for sequentially measuring the plurality of measurement regions. The measurement sequence is formed from a plurality of measurement steps corresponding to the plurality of measurement regions. The measurement sequence is also called a recipe.

Each individual measurement step of the measurement sequence is formed from one or a plurality of measurement operations. For example, a certain measurement step may be formed from a single measurement operation (for example, image acquisition), and another measurement step may be formed from two measurement operations (for example, image acquisition and analysis). In some cases, one measurement step may be formed from three or more measurement operations.

Document 1 (JP 2016-38210 A) discloses a spectroscopic analysis apparatus having a mechanism for managing an analysis position, an analysis method, and an analysis setting. Document 2 (JP 2001-35893 A) discloses a circuit pattern inspection apparatus formed from a scanning electron microscope. Documents 1 and 2 do not disclose a technique for expressing, in a visually easily understandable manner, both the plurality of measurement steps forming the measurement sequence and the plurality of measurement operations included in the plurality of measurement steps. In particular, Documents 1 and 2 fail to disclose a technique for producing an image having two intersecting time axes.

Document 3 (JP 2011-53787 A) discloses an image processing apparatus which is used in the field of factory automation. On a display device of this apparatus, a flow representing parallel processes is displayed. The image processing apparatus of Document 3 is not related to sample measurement using an electron beam. The flow disclosed in Document 3 does not have two intersecting time axes.

As described above, a measurement sequence for multi-point measurement in a charged particle beam apparatus such as the scanning electron microscope is formed from a plurality of measurement steps which are sequentially executed. This series of the plurality of measurement step can be referred to as a main flow. Each individual measurement step in the measurement sequence is formed from one or a plurality of measurement operations. The one or plurality of measurement operations of each measurement step can be referred to as a sub flow.

Contents of the measurement sequence for multi-point measurement are in general complicated. When setting the measurement sequence, the user tends to be puzzled or to misunderstand. For example, it tends to be difficult to understand to which measurement step or measurement operation in the measurement sequence a measurement condition which is currently being set corresponds. During execution of the measurement sequence also, it tends to be difficult to understand to what part of the measurement sequence the measurement operation which is currently being executed corresponds.

An advantage of the present disclosure lies in assisting the user in setting and/or executing a measurement sequence formed from a plurality of measurement steps. Alternatively, an advantage of the present disclosure lies in expressing in a visually easily understandable manner the measurement sequence formed from the plurality of measurement steps.

### SUMMARY

According to one aspect of the present disclosure, there is provided a charged particle beam apparatus comprising: a measurement unit that includes a facility to irradiate a sample with an electron beam, and that measures the sample; a control unit configured to control the measurement unit according to a measurement sequence including a plurality of measurement steps; a flow image producer that produces a flow image representing the measurement sequence; and a display that displays the flow image, wherein the flow image has a main flow direction and a sub flow direction which intersect each other, the flow image includes a plurality of graphics representing the plurality of measurement steps, and arranged along the main flow direction according to an order of execution of the plurality of measurement steps, the plurality of graphics include at least one multi-graphic representing a multi-measurement step including a plurality of measurement operations, and each of the at least one multi-graphic includes a plurality of symbols representing the plurality of measurement operations, and arranged along the sub flow direction according to an order of execution of the plurality of measurement operations.

According to another aspect of the present disclosure, there is provided an image production method of producing a flow image, wherein the flow image is an image representing a measurement sequence including a plurality of measurement steps that are sequentially executed by a charged particle beam apparatus, and which is displayed at the time of setting the measurement sequence and during execution of the measurement sequence, the flow image has a main flow direction and a sub flow direction which are orthogonal to each other, the flow image includes a plurality of graphics representing the plurality of measurement steps, and arranged along the main flow direction according to an order of execution of the plurality of measurement steps, the plurality of graphics include at least one multi-graphic representing a multi-measurement step including a plurality of measurement operations, and each of the at least one multi-graphic includes a plurality of symbols representing the plurality of measurement operations, and arranged along the sub flow direction according to an order of execution of the plurality of measurement operations.

### BRIEF DESCRIPTION OF DRAWINGS

Embodiment(s) of the present disclosure will be described based on the following figures, wherein
FIG. 1 is a block diagram showing a scanning electron microscope according to an embodiment of the present disclosure;
FIG. 2 is a diagram showing an example of a data set:
FIG. 3 is a diagram showing an example of a composite image displayed at the time of setting a measurement sequence;
FIG. 4 is a diagram showing a change of a flow image and a change of an overhead image;
FIG. 5 is a diagram showing a first example of a composite image displayed during execution of the measurement sequence;
FIG. 6 is a diagram showing a second example of a composite image displayed during execution of the measurement sequence;
FIG. 7 is a diagram showing a third example of a composite image displayed during execution of the measurement sequence;
FIG. 8 is a diagram showing an example of a composite image displayed at the time of completion of the measurement sequence;
FIG. 9 is a diagram showing management of a plurality of groups of layouts;
FIG. 10 is a flowchart showing an operation at the time of setting the measurement sequence;
FIG. 11 is a flowchart showing an operation during execution of the measurement sequence;
FIG. 12 is a diagram showing setting of the measurement sequence based on a template; and
FIG. 13 is a diagram showing an alternative example of the flow image.

### DESCRIPTION OF EMBODIMENTS

An embodiment of the present disclosure will now be described with reference to the drawings.

### (1) Overview of Embodiment

A charged particle beam apparatus according to an embodiment of the present disclosure comprises a measurement unit, a control unit, a flow image producer, and a display. The measurement unit includes a facility to irradiate a sample with an electron beam, and measures the sample. The control unit controls the measurement unit according to a measurement sequence including a plurality of measurement steps. The flow image producer produces a flow image representing the measurement sequence. The display displays the flow image. The flow image has a main flow direction and a sub flow direction which intersect each other. The flow image includes a plurality of graphics representing the plurality of measurement steps, and arranged along the main flow direction according to an order of execution of the plurality of measurement steps. The plurality of graphics include at least one multi-graphic representing a multi-measurement step including a plurality of measurement operations. Each of the at least one multi-graphic includes a plurality of symbols representing the plurality of measurement operations, and arranged along the sub flow direction according to an order of execution of the plurality of measurement operations. A processor to be described later functions as the control unit and the flow image producer.

According to the above-described structure, because the flow image has the main flow direction and the sub flow direction which are separated from each other, a user observing the flow image can easily recognize the flow of the measurement sequence as a whole, and, at the same time, the user can easily recognize the contents of each measurement step. In particular, the user can easily recognize the structure and the flow of a multi-measurement step. Each graphic corresponds to a display object. Each symbol corresponds to an icon.

In an embodiment of the present disclosure, the flow image is displayed at the time of setting the measurement sequence and during execution of the measurement sequence. According to this structure, it is possible to assist setting of the measurement sequence by the user. In addition, the user can easily understand the contents and progress of the measurement sequence during execution of the measurement sequence.

In an embodiment of the present disclosure, the charged particle beam apparatus is a scanning electron microscope. The plurality of symbols arranged along the sub flow direction include an imaging symbol and an analysis symbol. The imaging symbol is a symbol representing a measurement operation to produce an electron microscope image by detecting electrons emitted from the sample. The analysis symbol is a symbol representing a measurement operation to analyze the sample by detecting an X-ray emitted from the sample. Alternatively, symbols other than the imaging symbol and the analysis symbol may be prepared.

In an embodiment of the present disclosure, the analysis symbol is one or both of a spectrum analysis symbol representing a measurement operation to produce an X-ray spectrum as an analysis result, and a map analysis symbol representing a measurement operation to produce an element map as an analysis result. Alternatively, analysis symbols other than the spectrum analysis symbol and the map analysis symbol may be prepared.

In an embodiment of the present disclosure, the flow image further includes a completion graphic representing completion of the measurement sequence. The completion graphic includes a display element representing presence or absence of execution of a particular completion operation. According to this structure, the user can recognize in advance the operation at the time of completion of the measurement sequence.

A charged particle beam apparatus according to an embodiment of the present disclosure further comprises an overhead image producer that produces an overhead image including a plurality of marks representing a plurality of measurement regions which are set on the sample. The overhead image is displayed along with the flow image at least at the time of setting the measurement sequence. According to this structure, the measurement sequence can be set accurately and easily. A processor to be described later functions as the overhead image producer.

In an embodiment of the present disclosure, when a particular measurement region is selected from among the plurality of measurement regions, the overhead image producer emphasizes a particular mark corresponding to the particular measurement region, and, at the same time, the flow image producer emphasizes all or a part of a particular graphic corresponding to the particular measurement region. Meanwhile, when a particular measurement step is selected from among the plurality of measurement steps, the flow image producer emphasizes all or a part of a particular graphic corresponding to the particular measurement step, and, at the same time, the overhead image producer emphasizes a particular mark corresponding to the particular measurement step. This structure allows the user to accurately recognize a correspondence relationship between the plurality of measurement regions and the plurality of measurement steps. The particular mark or the particular graphic may be emphasized by setting a display form of the particular mark or the particular graphic to differ from a display form of other marks or the other graphics.

A charged particle beam apparatus according to an embodiment of the present disclosure further comprises a report producer that produces a plurality of reports corresponding to the plurality of measurement steps. The report producer includes a function to produce a plurality of provisional reports as the plurality of reports, and a function to produce a plurality of actual reports as the plurality of reports based on a result of execution of a plurality of measurement steps. All or a part of the plurality of provisional reports are displayed at the time of setting the measurement sequence, and all or a part of the plurality of actual reports are displayed after completion of the measurement sequence. A processor to be described later functions as the report producer.

According to the above-described structure, it is possible to check in advance the content of the actual report (more specifically, a layout) produced by the execution of the measurement step, through reference to the provisional report at the time of setting the measurement sequence. In addition, because the actual report is automatically displayed after the completion of the measurement sequence, the burden of the user in the production of the report can be reduced.

In an embodiment of the present disclosure, a report which is being displayed changes from the provisional report to the actual report during execution of or at the completion of the execution of each measurement step of the plurality of measurement steps. According to this structure, it is possible to display the actual report at an early stage without waiting for the completion of the execution of the measurement sequence.

A charged particle beam apparatus according to an embodiment of the present disclosure further comprises a storage that stores a plurality of measurement condition sets for executing the plurality of measurement steps. Each of the plurality of measurement condition sets includes a common measurement condition and one or a plurality of individual measurement conditions. An image for setting a measurement condition is displayed along with the flow image at least at the time of setting the measurement sequence. According to this structure, the measurement conditions can be set while referring to the flow image.

An image production method according to an embodiment of the present disclosure is an image production method of producing a flow image. The flow image is an image representing a measurement sequence including a plurality of measurement steps which are sequentially executed by a charged particle beam apparatus, and which is displayed at the time of setting the measurement sequence and during execution of the measurement sequence. The flow image has a main flow direction and a sub flow direction which are orthogonal to each other. The flow image includes a plurality of graphics representing the plurality of measurement steps, and arranged along the main flow direction according to an order of execution of the plurality of measurement steps. The plurality of graphics include at least one multi-graphic representing a multi-measurement step including a plurality of measurement operations. Each of the at least one multi-graphic includes a plurality of symbols representing the plurality of measurement operations, and arranged along the sub flow direction according to an order of execution of the plurality of measurement operations.

The above-described image production method is realized as a function of hardware or a function of software. In an embodiment of the present disclosure, a program or a program product for executing the image production method is installed in an information processing apparatus via a network or a transportable recording medium. The information processing apparatus has a storage which non-transitorily stores a program, and a processor which executes the program.

### (2) Details of Embodiment

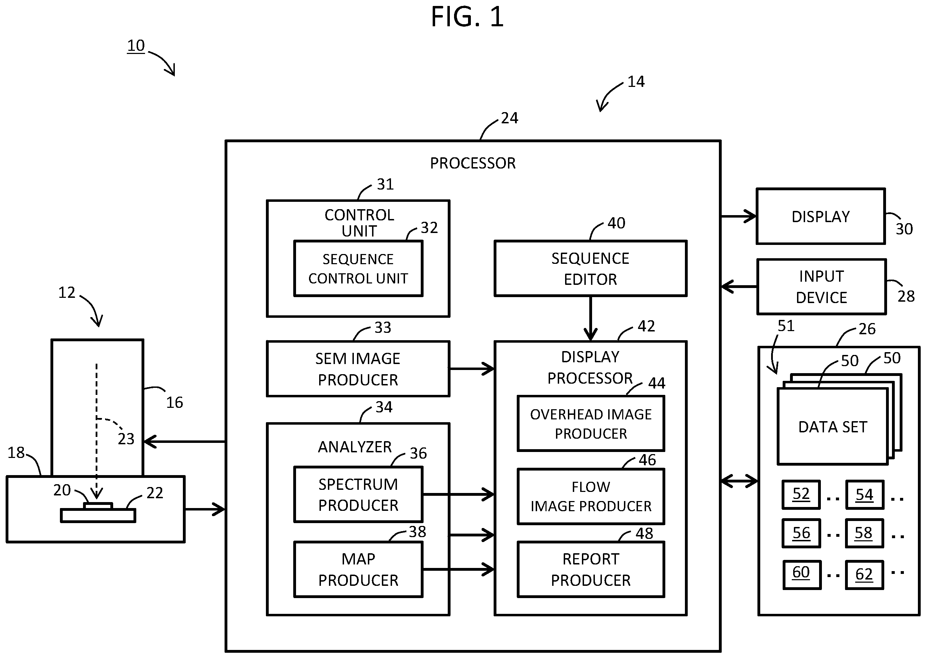

FIG. 1 shows a charged particle beam apparatus according to an embodiment of the present disclosure. The charged particle beam apparatus is specifically a scanning electron microscope 10 which measures a sample. The scanning electron microscope 10 includes a measurement unit 12 and an information processor 14.

The measurement unit 12 has an optical column 16 and a housing 18. In the optical column 16, an electron gun, a scanning coil, an objective lens, and the like are housed. These elements are a facility for irradiating a sample 20 with an electron beam 23 serving as a charged particle beam. An interior of the housing 18 is a sample chamber. A movable stage 22 is provided in the sample chamber. The movable stage 22 is a facility which supports or holds the sample 20. The electron beam 23 is radiated with respect to each of measurement regions which are set on a surface of the sample 20, and the electron beam 23 is two-dimensionally scanned in each measurement region.

The measurement unit 12 has a secondary electron detector, a backscattered electron detector, an X-ray detector, or the like. As the secondary electron detector, a plurality of detectors may be provided. Alternatively, a soft X-ray detector may be provided. The X-ray detector is, for example, an EDS (Energy Dispersive X-ray Spectroscopy) detector. Alternatively, an X-ray detector of a different type may be used. The measurement unit 12 has a CCD camera which images the surface of the sample 20. With the CCD camera, an optical image representing the surface of the sample 20 is acquired. The measurement unit 12 has a power supply for supplying voltages to the electron gun and the plurality of detectors, a shutter which partitions the internal space of the optical column 16, and the like.

The information processor 14 is formed from, for example, a computer. The information processor 14 includes a processor 24, a storage 26, an input device 28, and a display 30. The processor 24 is formed from, for example, a CPU, a GPU, or the like, which executes a program. The storage 26 is formed from a semiconductor memory, a hard disk drive, or the like. The input device 28 is formed from a keyboard, a pointing device, or the like. The display is formed from an LCD or the like. Alternatively, the display 30 may be formed from a plurality of display devices. Alternatively, the processor 24 may be formed from a plurality of information processing devices.

In FIG. 1, a plurality of functions realized by the processor 24 are represented with a plurality of blocks. A control unit 31 is a controller which controls operations of the measurement unit 12. With the control unit 31, for example, operations of the movable stage 22 are controlled, irradiation with the electron beam is controlled, and detection of the electrons and X-rays is controlled.

The control unit 31 functions as a sequence control unit 32. The sequence control unit 32 controls operations of the measurement unit 12 according to a particular measurement sequence which is set or selected by a user. Each measurement sequence includes a plurality of measurement steps corresponding to the plurality of measurement regions. The measurement sequence is also called a measurement protocol or a recipe.

An SEM image producer 33 produces an SEM image based on detection data which are input. For example, the SEM image producer 33 produces the SEM image based on detection data which are output from the secondary electron detector, or produces the SEM image based on detection data which are output from the backscattered electron detector. Alternatively, the SEM image may be produced based on other detection data.

The processor 24 also has a function to produce an optical image based on a signal from the CCD camera. The SEM image is a two-dimensional image representing the surface of the sample 20, and the optical image is also a two-dimensional image representing the surface of the sample 20.

An analyzer 34 analyzes the sample by analyzing detection data which is output from the X-ray detector. The detection data is more specifically characteristic X-ray detection data. The analyzer 34 includes a spectrum producer 36 and a map producer 38.

The spectrum producer 36 produces an X-ray spectrum based on the detection data. The X-ray spectrum normally includes a plurality of peaks. To each peak, element information and characteristic X-ray type information are added. The map producer 38 produces a plurality of element maps based on the detection data. The map producer 38 also has a function to produce a combined map by combining a plurality of element maps. Alternatively, a two-dimensional image representing the measurement region may be produced based on a plurality of accumulated spectrum information acquired from a plurality of measurement points forming the measurement region.

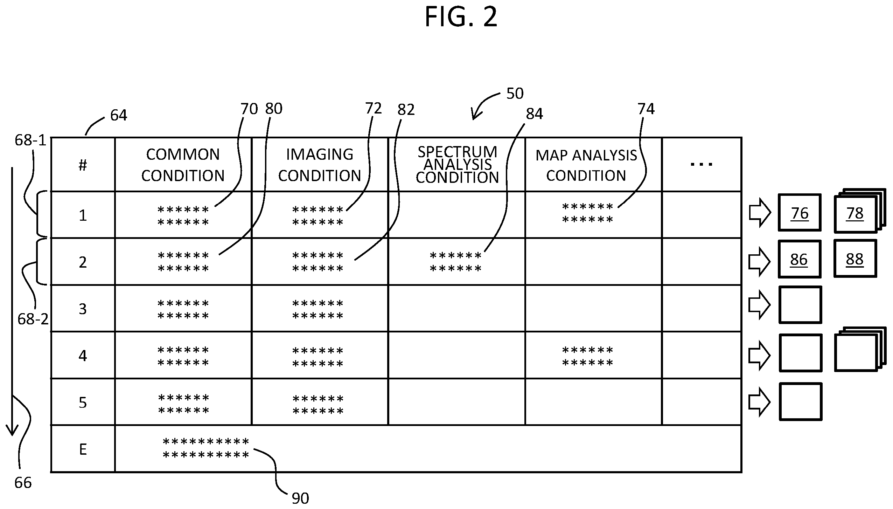

A sequence editor 40 produces or changes a measurement sequence for multi-point continuous measurement based on an input or a designation of the user. Normally, at the time of setting the measurement sequence, a plurality of measurement regions are sequentially designated on the surface of the sample 20. For each measurement region, a measurement step is defined. Each measurement step is formed from one or a plurality of measurement operations. In the setting of a plurality of measurement steps, a flow image, details of which are to be described below, is produced and used. The plurality of measurement steps forming the measurement sequence are defined by a plurality of measurement conditions. Each measurement condition includes a common measurement condition and one or a plurality of individual measurement conditions. An individual measurement condition is actually a plurality of parameters. In other words, the measurement sequence is actually a parameter set. This point will be described later in detail with reference to FIG. 2.

A display processor 42 produces a display image to be displayed on a screen of the display 30. The display processor 42 functions as an overhead image producer 44, a flow image producer 46, and a report producer 48.

The overhead image producer 44 produces an overhead image representing the surface of the sample 20. The overhead image is formed from a background image and a plurality of marks representing the plurality of measurement regions. The overhead image has a first spatial axis and a second spatial axis which are mutually orthogonal.

More specifically, the background image is an optical image, an SEM image, or a combined image. The combined image is an image produced through combination of the optical image and the SEM image having the same display magnification. Alternatively, as the background image, an artificial image such as a CAD image may be employed.

As described, the overhead image includes a plurality of marks representing the plurality of measurement regions. Each mark is a figure, and is specifically a frame representing an outer edge of the measurement region. The inside of the frame may be filled in as necessary. For each measurement region, an arbitrary observation magnification may be designated.

The flow image producer 46 produces a flow image representing the measurement sequence at the time of setting the measurement sequence or during execution of the measurement sequence. The flow image is formed from a plurality of graphics which are connected to each other, and is more specifically formed from a plurality of graphics representing the plurality of measurement steps, and a completion graphic representing completion of the measurement sequence.

The flow image has a main flow direction and a sub flow direction which intersect each other (more specifically, which are orthogonal to each other). In the embodiment, the main flow direction is a horizontal direction or a lateral direction, and the sub flow direction is a vertical direction or a perpendicular direction. The plurality of graphics are arranged along the main flow direction.

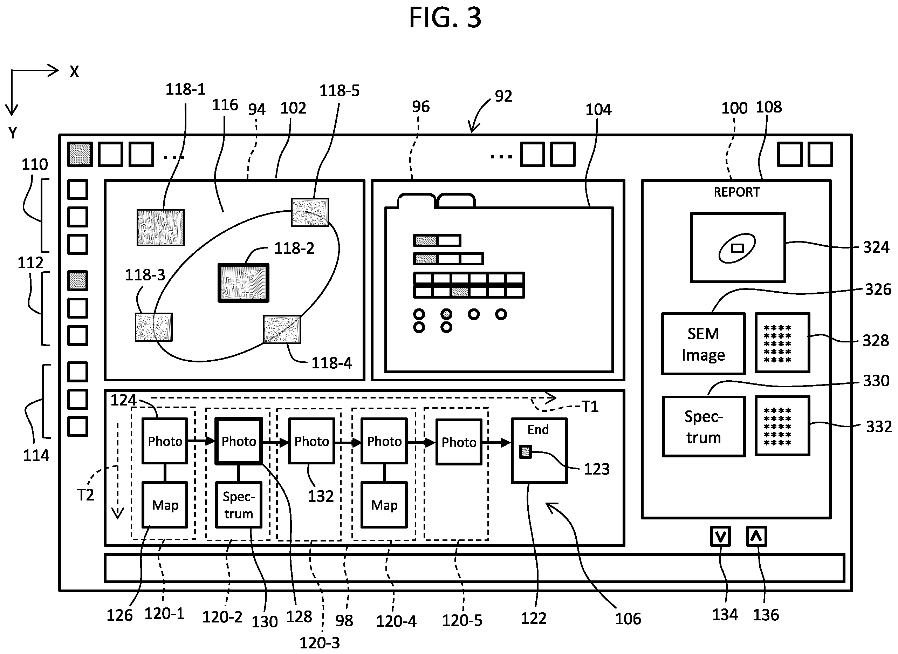

The graphic representing each measurement step is a single graphic or a multi-graphic. The single graphic represents a measurement step formed from a single measurement operation. The multi-graphic represents a measurement step formed from a plurality of measurement operations which are sequentially executed. More specifically, the single graphic is formed from a single symbol representing the single measurement operation. The multi-graphic is formed from a plurality of symbols representing the plurality of measurement operations. The plurality of symbols are arranged along the sub flow direction. Each symbol is a display element including a figure, a text, or the like, and may be called an icon. In FIG. 3, each symbol is represented abstractly or exemplarily. The flow image will be described later in detail with reference to FIGs. 3 and on.

Referring to FIG. 1, the report producer 48 has a provisional report producing function and an actual report producing function. The provisional report is a report sample or a dummy report. At the time of setting the measurement step, a layout of the report is designated. The provisional report is an image showing the layout. On the other hand, the actual report is a substantial report reflecting a result of imaging or a result of analysis at the measurement step. The report may be produced simultaneously with the execution of each measurement step, or the report may be produced after completion of each measurement step.

The storage 26 stores a plurality of data sets 50 which define a plurality of measurement sequences. Alternatively, a data set which was produced in the past may be reused. The storage 26 also stores an optical image 52, a plurality of SEM images 54, a plurality of X-ray spectra 56, a plurality of element maps 58, a plurality of layouts 60, a plurality of actual reports 62, and the like. The storage 26 is formed from, for example, one or a plurality of semiconductor memories.

FIG. 2 shows an example of the data set 50. The data set 50 corresponds to the actual entity of the measurement sequence, and may thus be also called a measurement condition set or a parameter set. Reference numeral 66 shows a time axis. The measurement sequence is formed from a plurality of measurement steps. Reference numeral 64 shows a measurement step number. Reference numeral 68-1 shows a group of parameters corresponding to a first measurement step. The group of parameters 68-1 include a plurality of parameters 70 for defining common conditions, a plurality of parameters 72 for defining the imaging conditions, and a plurality of parameters 74 for defining map analysis conditions.

Reference numeral 68-2 shows a group of parameters corresponding to a second measurement step. The group of parameters 68-2 include a plurality of parameters 80 for defining common conditions, a plurality of parameters 82 for defining the imaging conditions, and a plurality of parameters 84 for defining spectrum analysis conditions. For each measurement step, a parameter for designating the report layout is also managed.

The common conditions are common measurement conditions in the imaging operation, the spectrum analysis operation, and the map analysis operation. The common conditions include, for example, a measurement magnification, a movable stage position, an acceleration voltage, a work distance (WD), or the like. The imaging conditions are measurement conditions for defining the imaging operation. The imaging conditions include, for example, a detector type, an imaging mode, a scan speed, an acquired image size, or the like. The spectrum analysis conditions are measurement conditions for defining the spectrum analysis. The spectrum analysis conditions include a stopping condition, a condition related to qualitative analysis, a condition related to quantitative analysis, or the like. The map analysis conditions are measurement conditions for defining the map analysis. The map analysis conditions include a resolution, a stopping condition, a condition related to qualitative analysis, or the like.

The data set 50 also includes an operation condition at the time of completion of the measurement sequence (completion condition). In the illustrated example structure, the completion condition is defined by a plurality of parameters 90. The completion condition may include stopping of application of the voltage to the detector, an operation of the shutter provided in the optical column, or the like. Alternatively, as the completion condition, movement of the movable stage, release of a lock of a measurement chamber door, or the like may be defined.

A plurality of data are produced through execution of each measurement step. These data are stored in the storage. For example, with the execution of the first measurement step, an SEM image 76 is produced, and then, a plurality of element maps 78 are produced. With the execution of the second measurement step, an SEM image 86 is produced, and then, an X-ray spectrum 88 is produced.

FIG. 3 shows a display image (hereinafter, referred to as a "composite image") 92 displayed on the screen at the time of setting the measurement sequence. The composite image 92 may also be called an UI (User Interface) image. Through the composite image 92, the user designates a plurality of measurement regions, and, through the composite image 92, the user defines a plurality of measurement steps forming the measurement sequence.

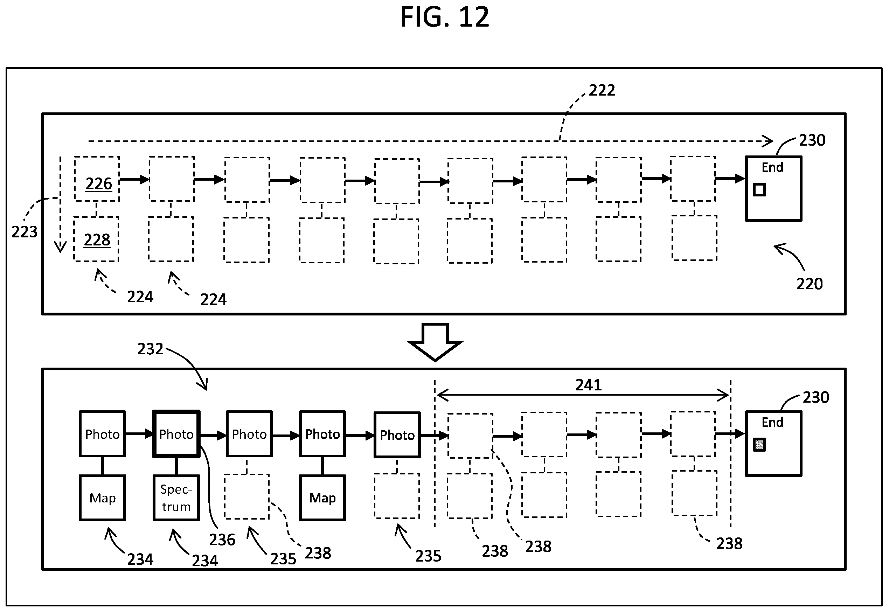

The composite image 92 has a first display region 94, a second display region 96, a third display region 98, and a fourth display region 100. At the time of setting the measurement sequence, an overhead image 102 is displayed in the first display region 94, an image for setting the measurement condition 104 is displayed in the second display region 96, and a flow image 106 is displayed in the third display region 98. A report (report image) 108 is displayed in the fourth display region 100. The composite image 92 shown in FIG. 3 is a composite image displayed at the time of completion of the setting of the measurement sequence. The flow image displayed before the start of the setting of the measurement sequence and during the setting will be described later with reference to FIG. 12.

Reference numeral 110 shows a plurality of buttons manipulated when the measurement sequence is edited. Reference numeral 112 shows a plurality of buttons manipulated when the type of the measurement step is designated. For example, these buttons correspond to the imaging, the spectrum analysis, and the map analysis. Reference numeral 114 shows a plurality of buttons manipulated during the execution of the measurement sequence. For example, these buttons are a start button, a stop button, and a skip button. Each button is a virtual button, and corresponds to an icon.

The overhead image 102 is an image produced by the overhead image producer. In the illustrated example structure, the overhead image 102 has a background image 116 and a plurality of marks 118-1 to 118-5. The background image 116 is the optical image, the SEM image, or a combined image. The combined image is an image produced by overlapping the SEM image over the optical image. Alternatively, as the background image 116, a CAD image representing a sample holder may be used.

The overhead image 102 is an image representing the surface of the sample, and has a first spatial axis and a second spatial axis which are mutually orthogonal. On the overhead image 102, the user sequentially sets the plurality of measurement regions. With this process, the plurality of marks 118-1 to 118-5 representing the plurality of measurement regions (more specifically, a first measurement region to a fifth measurement region) are displayed on the background image 116. In the illustrated example structure, each of the marks 118-1 to 118-5 is a quadrangular frame. The interior of each of the marks 181-1 to 118-5 is filled in, in such a manner as to allow the background image to be viewed therethrough.

For example, based on a designation of a coordinate by the user, a measurement region centered at the coordinate is set. Alternatively, based on a designation of a region by the user, the region is set as the measurement region. Alternatively, the plurality of measurement regions may be automatically set based on a result of image analysis.

The flow image 106 has a main flow direction T1 and a sub flow direction T2 which are mutually orthogonal. The main flow direction T1 is a horizontal direction or a lateral direction, and the sub flow direction is a vertical direction or a perpendicular direction. The main flow direction T1 corresponds to a first time axis, and the sub flow direction T2 corresponds to a second time axis.

The flow image 106 includes a plurality of graphics 120-1 to 120-5 representing a plurality of measurement steps, and a graphic 122 representing the completion of the measurement sequence. The plurality of graphics 120-1 to 120-5 and 122 are arranged along the main flow direction T1. Two graphics which are adjacent to each other are connected to each other via an arrow mark.

In the illustrated example structure, the first measurement region is correlated to the first measurement step, the second measurement region is correlated to the second measurement step, the third measurement region is correlated to the third measurement step, the fourth measurement region is correlated to the fourth measurement step, and the fifth measurement region is correlated to the fifth measurement step.

Each measurement step can be classified into a single-measurement step formed from a single measurement operation, or a multi-measurement step formed from a plurality of measurement operations. A graphic corresponding to the single-measurement step is a single graphic. The single graphic has a single symbol representing the single measurement operation. A graphic corresponding to the multi-measurement step is a multi-graphic. The multi-graphic includes a plurality of symbols which represent the plurality of measurement operations which are sequentially executed, and which are connected to each other. The plurality of symbols are arranged along the sub flow direction T2. Two symbols which are adjacent to each other are connected to each other by a line. Alternatively, in place of the line, a downward pointing arrow mark may be employed.

For example, the graphic 120-1 is the multi-graphic, and is formed from a symbol 124 representing the imaging operation, and a symbol 126 representing the map analysis operation. The symbols are arranged along the sub flow direction T2. The graphic 120-2 is also the mulita-graphic, and is formed from a symbol 128 representing the imaging operation, and a symbol 130 representing the spectrum analysis operation. The symbols are arranged along the sub flow direction t2. The graphic 120-3 is the single graphic, and is formed from a symbol 132 representing the imaging operation.

The graphic 122 has a display element 123. The display element 123 is a check box, and, by checking the check box, a predetermined completion operation is automatically executed at the time of completion of the measurement sequence. Alternatively, the graphic 122 may include a plurality of display elements corresponding to a plurality of completion operations.

In the illustrated example structure, the symbol 128 representing the imaging operation in the second measurement step is emphasized, and the mark 118-2 representing the second measurement region is also emphasized. As a form of the emphasis, there may be exemplified widening of a line width, an increased luminosity, a changed hue, and the like. Alternatively, the entirety of the graphic 120-2 including the symbol 128 may be emphasized.

In a state in which the imaging operation is selected, the image 104 for setting the imaging operation is displayed in the second display region 96. In a state in which the map analysis operation is selected, an image for setting the map analysis condition is displayed in the second display region 96. In a state in which the spectrum analysis operation is selected, an image for setting the spectrum analysis condition is displayed in the second display region 96. An image for setting the common measurement condition may be displayed in the second display region 96 by a tab-switching operation at an arbitrary timing.

The report 108 corresponding to the measurement step or the measurement operation which is currently selected is displayed in the fourth display region. The report 108 displayed at the time of setting the measurement sequence is the provisional report. The report 108 includes an optical image or an overhead image 324, a dummy SEM image 326, an SEM image acquisition condition 328, a dummy spectrum 330, and a spectrum acquisition condition 332. Buttons 134 and 136 are page switching buttons.

According to the embodiment of the present disclosure, the user can simultaneously refer to the overhead image 102 and the flow image 106 displayed on the same screen at the time of setting the measurement sequence. Therefore, it becomes possible to correctly design the measurement sequence while taking into consideration the correspondence relationship between the plurality of measurement regions and the plurality of measurement steps. Further, because the flow image 106 includes the main flow direction T1 and the sub flow direction T2, the user can intuitively understand the structure of the measurement sequence as a whole, and the structure of each measurement step. Alternatively, in the overhead image 102, an identifier indicating the measurement step may be displayed along with each of the marks 118-1 to 118-5. Similarly, in the flow image 106, an identifier indicating the measurement step may be displayed along with each of the graphics 120-1 to 120-5.

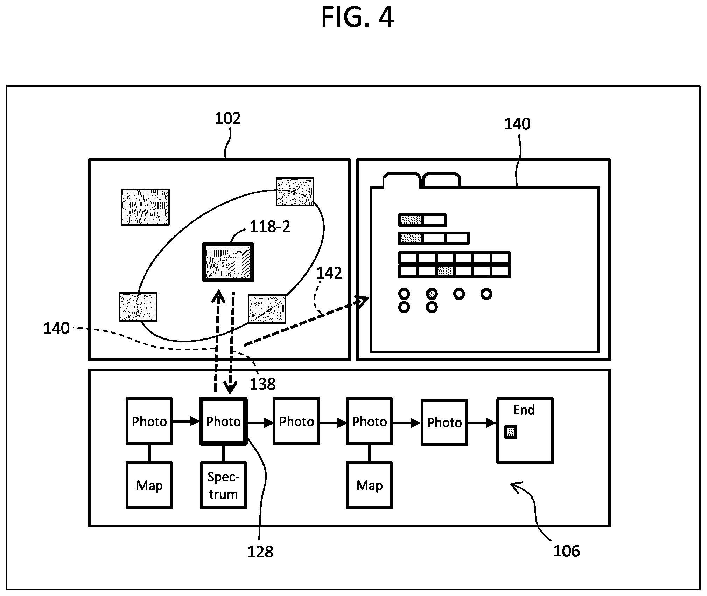

FIG. 4 shows a part of the composite image shown in FIG. 3. More specifically, FIG. 4 shows the overhead image 102, an image 140 for setting the measurement condition, and the flow image 106. When the user selects a particular measurement region during the setting of the measurement sequence, the mark 118-2 representing the particular measurement region is emphasized. At the same time, all or a part of a particular graphic corresponding to the particular measurement region is emphasized (refer to reference numeral 138). In the illustrated example structure of FIG. 4, the particular symbol 128 included in the particular graphic is emphasized. In the situation in which the particular symbol 128 is emphasized, the image 140 for setting the imaging condition is displayed in the second display region (refer to reference numeral 142).

Meanwhile, when the user selects a particular measurement operation, the particular symbol 128 representing the particular measurement operation is emphasized. At the same time, the particular mark 118-2 representing a particular measurement region corresponding to the particular measurement operation is emphasized. In this manner, the contents of the plurality of images vary depending on the selection manipulation of the user. Therefore, workability at the time of the setting of the measurement sequence can be improved.

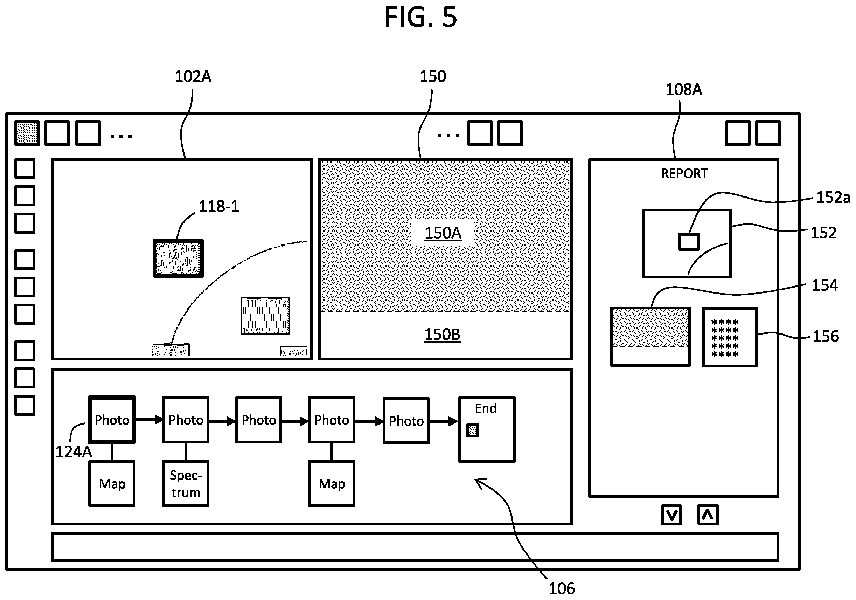

FIG. 5 shows a first example of the composite image displayed during the execution of the measurement sequence. Currently, a first measurement operation (imaging operation) in the first measurement step is being executed. A symbol 124A is emphasized in the flow image 106. In an overhead image 102A, the mark 118-1indicating the first measurement region is emphasized.

In the illustrated example structure of FIG. 5, an SEM image 150 is displayed in the second display region. The SEM image 150 is a real-time image or a live image. Reference numeral 150A shows an image portion which is already produced, and reference numeral 150B shows an image portion to be produced in the future. Alternatively, the SEM image 150 may be displayed in the first display region in place of the overhead image 102A.

A report 108A includes an optical image or an overhead image 152. In the illustrated example structure, the image 152 includes a mark 152a indicating the first measurement region. In addition, the report 108A includes an SEM image 154 in the middle of production, and also includes a measurement condition 156 for acquiring the SEM image. In this manner, the content of the report may be gradually switched from the provisional report to the actual report during the execution of the measurement step. Alternatively, the content of the report as a whole may be switched from the provisional report to the actual report at once, at the time of completion of the measurement step.

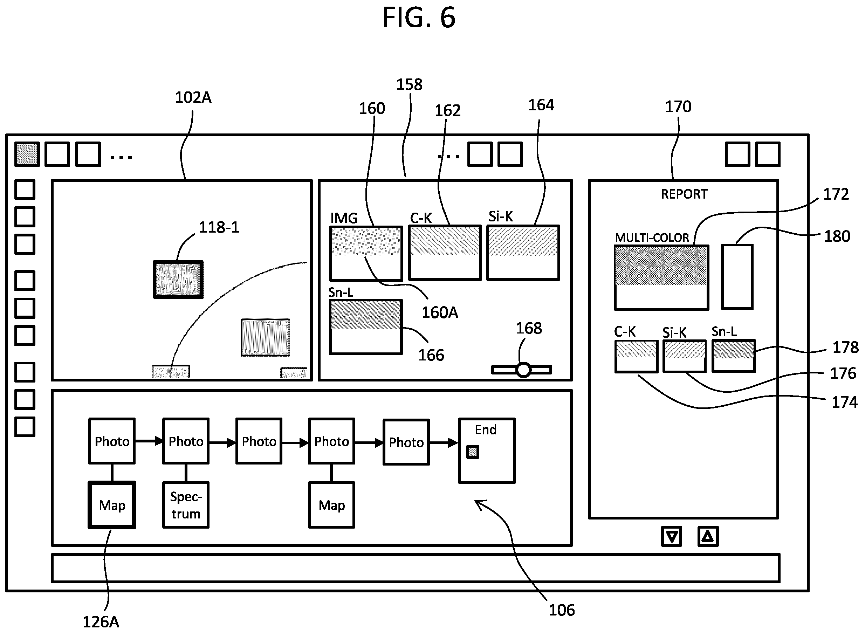

FIG. 6 shows a second example of the composite image displayed during the execution of the measurement sequence. Currently, a second measurement operation (map analysis) in the first measurement step is being executed. A symbol 126A is emphasized in the flow image 106. In the overhead image 102A, the mark 118-1 indicating the first measurement region is emphasized.

An image 158 representing the result of the map analysis is displayed in the second display region. The image 158 includes an SEM image 160 produced during the map analysis, and a plurality of element maps 162, 164, and 166. For example, the element map 162 is produced based on a characteristic X-ray (K line) emitted from a carbon atom, the element map 164 is produced based on a characteristic X-ray (K line) emitted from a silicon atom, and the element map 166 is produced based on a characteristic X-ray (L line) emitted from a tin atom.

A line 160A corresponds to a boundary between the image portion which is already formed and the image portion to be formed in the future. A slide bar 168 is manipulated when the image size or the display magnification is adjusted.

In the illustrated example structure, a report 170 includes a combined map 172 produced by combining a plurality of element maps. Further, the report 170 includes a measurement condition 180. The report 170 also includes element maps 174, 176, and 178 corresponding respectively to the above-described element maps 162, 164, and 166. As described above, the content of the report may be gradually switched from the provisional report to the actual report during the execution of the measurement step, or the content of the report as a whole may be switched from the provisional report to the actual report at once, at the time of completion of the measurement step.

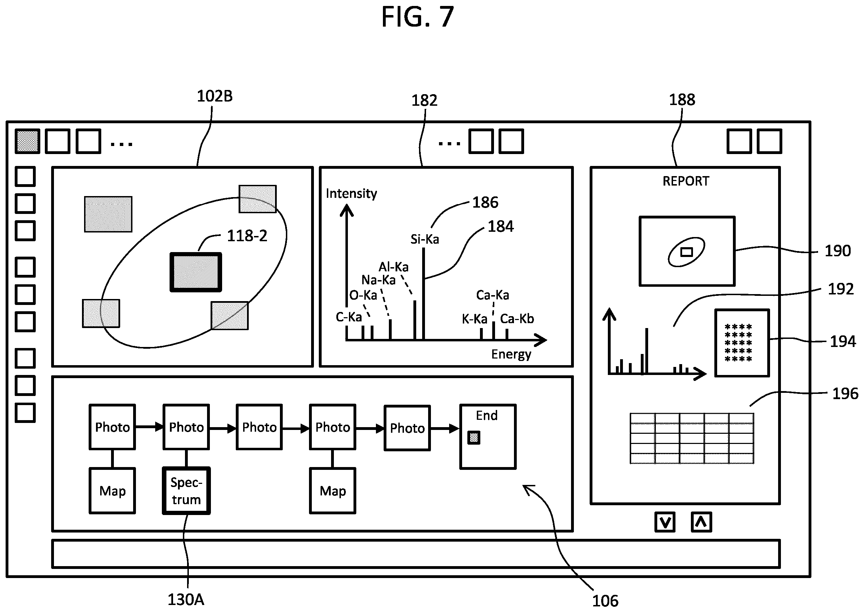

FIG. 7 shows a third example of the composite image displayed during the execution of the measurement sequence. Currently, a second measurement operation (spectrum analysis) in the second measurement step is being executed. A symbol 130A is emphasized in the flow image 106. In an overhead image 102B, the mark 118-2 indicating the second measurement region is emphasized.

An image 182 representing the result of the spectrum analysis is displayed in the second display region. The image 182 includes a spectrum. The horizontal axis is an energy axis, and the vertical axis is an intensity axis. The spectrum includes a plurality of peaks 184. Near each peak 184, information indicating an element, and information indicating the type of the characteristic X-ray are displayed (refer to reference numeral 186). Alternatively, in the first display region, an SEM image may be displayed in place of the overhead image 102B.

In the illustrated example structure, a report 188 includes an optical image or an overhead image 190, and also includes a spectrum 192. The report 188 further includes information 194 indicating the measurement condition, and numerical value information 196 showing the result of the spectrum analysis. As described above, the content of the report may be gradually switched from the provisional report to the actual report during the execution of the measurement step, or the content of the report as a whole may be switched from the provisional report to the actual report at once, at the time of completion of the measurement step.

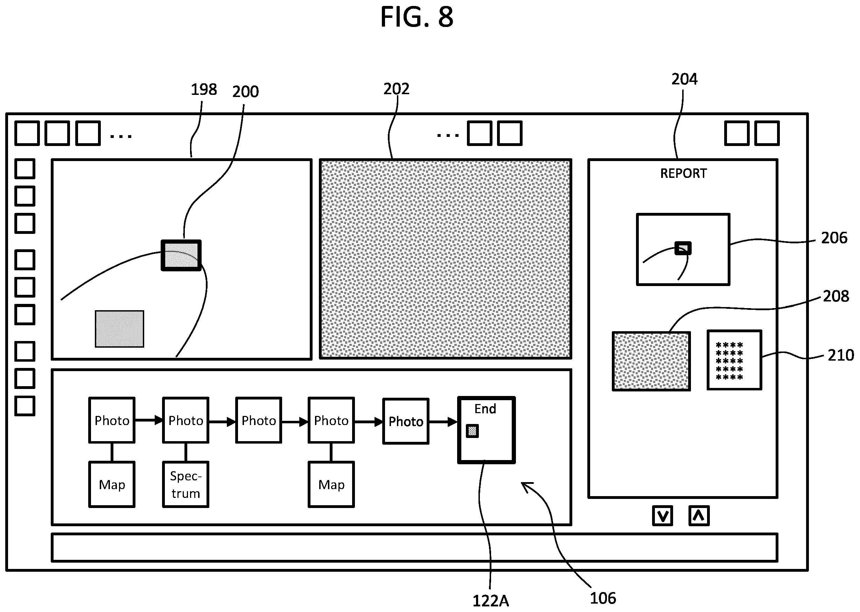

FIG. 8 shows the composite image displayed at the time of completion of the measurement sequence. In the flow image 106, a graphic 122A is emphasized. An overhead image 198 includes a mark 200 indicating the fifth measurement region. The overhead image 198 is displayed in such a manner that the mark 200 appears at the center of the first display region. Reference numeral 202 represents an SEM image acquired at the last measurement step. A report 204 includes an optical image or an overhead image 206, an SEM image 208, and information 210 representing the measurement condition.

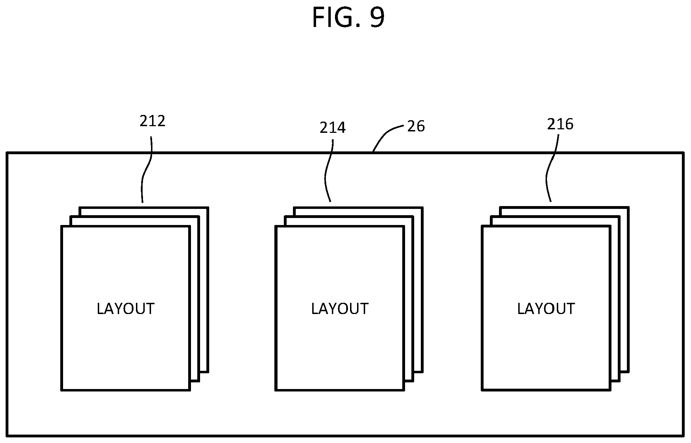

FIG. 9 shows three groups of layouts 212, 214, and 216 corresponding to three types of measurement operations. These groups of layouts are stored in the storage 26. For example, when the imaging operation is designated, a particular layout is selected from among the group of layouts 212. When the spectrum analysis operation is designated, a particular layout is selected from among the group of layouts 214, and, when the map analysis operation is designated, a particular layout is selected from among the group of layouts 216.

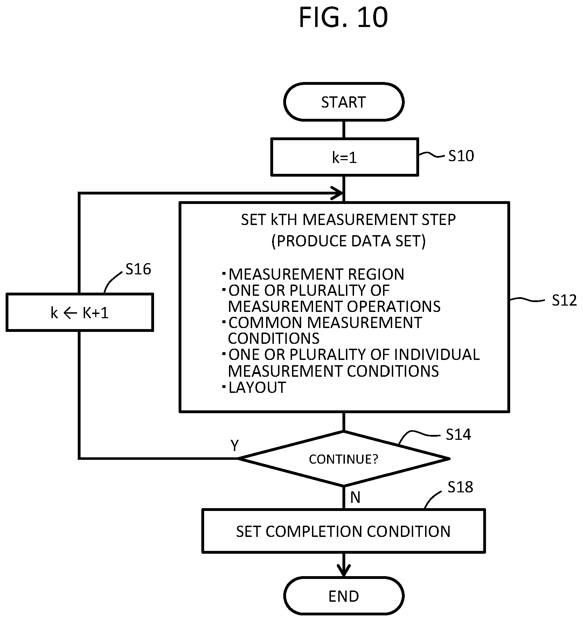

FIG. 10 shows an operation of the processor at the time of setting the measurement sequence as a flowchart. In S10, 1 is substituted into k. In S12, various conditions are set for a kth measurement step. More specifically, in S12, the measurement region is set based on the designation of the user, and one or a plurality of measurement operations are set based on an input of the user. Further, the common measurement condition is set based on the input of the user, and one or a plurality of individual measurement conditions are set. Further, in S12, the user selects the layout.

When continuation of the setting is determined in S14, in S16, (k+1) is substituted as new k, and S12 is again executed. When completion of the setting is determined in S14, in S18, the completion condition is set.

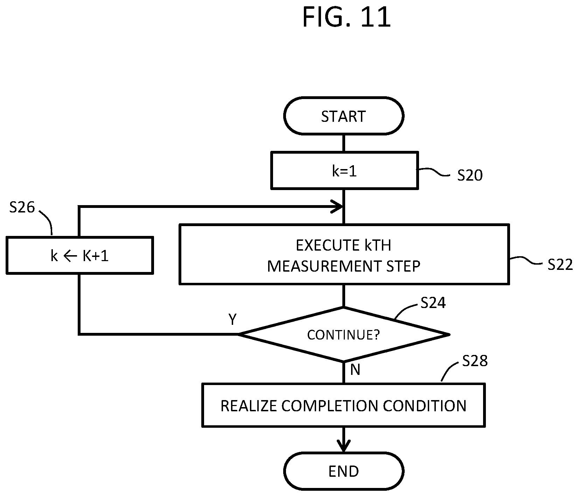

FIG. 11 shows an operation of the processor during the execution of the measurement sequence as a flowchart. In S20, 1 is substituted into k. In S22, a kth measurement step is executed. When the kth measurement step is the single-measurement step, one measurement operation is executed. On the other hand, when the kth measurement step is the multi-measurement step, a plurality of measurement operations are sequentially executed. When continuation is determined in S24, in S26, (k+1) is substituted as new k, and S22 is again executed. When completion of execution is determined in S24, in S28, control according to the completion condition is executed.

FIG. 12 shows at an upper part a template 220 for designing the measurement sequence. Reference numeral 222 shows the main flow direction, and reference numeral 223 shows the sub flow direction. A plurality of graphic candidates 224 are arranged along the main flow direction 222. Each graphic candidate 224 is displayed with a broken line or with low luminosity. Each graphic candidate 224 is formed from two symbol candidates 226 and 228 arranged along the sub flow direction 223. At the end of the template 220, a graphic 230 is included. The graphic 230 includes a display element indicating presence or absence of execution of the completion condition. On the template 220, a plurality of measurement operations are assigned to a plurality of symbol candidates in a time sequential order. With this process, the measurement region is designated for each measurement step.

FIG. 12 shows at a lower part a flow image 232 representing a measurement sequence which is currently being created. Each of several graphics 234 is formed from two symbols, and each of several graphics 235 is formed from one symbol. A symbol 236 is selected, and is thus emphasized. Reference numeral 238 shows a symbol candidate which is not used at the current time. Reference numeral 236 shows a symbol in the selected state. For example, in accordance with designation of a non-use section 241, a plurality of graphic candidates belonging to the non-use section 241 may be automatically deleted, or may be left without the deletion.

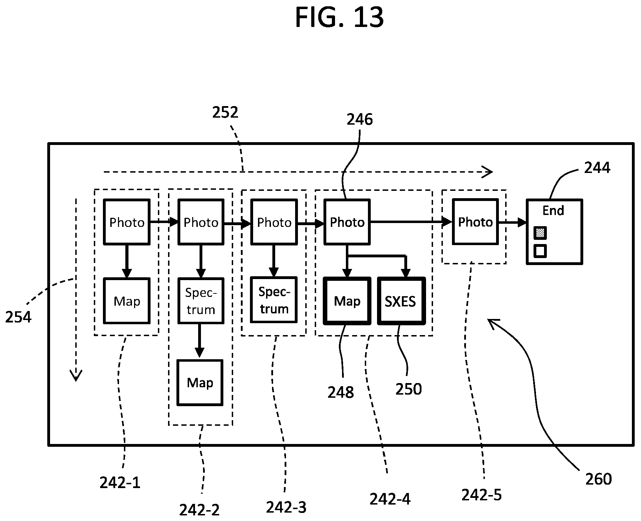

FIG. 13 shows an alternative configuration of the flow image. A flow image 260 includes a plurality of graphics 242-1 to 242-5 arranged along a main flow direction 252, and a completion graphic 244. Each of the plurality of graphics 242-1 to 242-3 is formed from a plurality of symbols arranged along a sub flow direction 254. The graphic 242-5 is a single graphic, and is formed from a single symbol.

In the illustrated example structure, the symbol 242-4 is formed from three symbols 246, 248, and 250. Symbols 248 and 250 are shown below the symbol 246, but in the sub flow direction 254, the position of the symbol 248 and the position of the symbol 250 are identical to each other. A measurement operation (for example, map analysis) represented by the symbol 248 and a measurement operation (for example, soft X-ray analysis) represented by the symbol 250 are executed simultaneously. At the current time, symbols 248 and 250 are emphasized.

According to the embodiment described above, because the flow image has the main flow axis and the sub flow axis, the user observing the flow image can easily recognize the flow of the measurement sequence as a whole, and, at the same time, can easily recognize the contents of each measurement step. In particular, with regard to the multi-measurement step, the structure and the flow can be easily recognized. Alternatively, the structure of the above-described embodiment may be applied to a charged particle beam apparatus other than the scanning electron microscope.

## Claims

1. A charged particle beam apparatus (10) comprising:
a measurement unit (12) that includes a facility to irradiate a sample with a charged particle beam, and that measures the sample;
aa control unit (31) configured to control the measurement unit (12) according to a measurement sequence including a plurality of measurement steps;
a flow image producer (46) that produces a flow image (106) representing the measurement sequence; and
a display (30) that displays the flow image (106), wherein
the flow image (106) has a main flow direction and a sub flow direction which intersect each other,
the flow image (106) includes a plurality of graphics (120, 122) representing the plurality of measurement steps, and arranged along the main flow direction according to an order of execution of the plurality of measurement steps,
the plurality of graphics (120, 122) include at least one multi-graphic representing a mulita-measurement step including a plurality of measurement operations, and
each of the at least one multi-graphic includes a plurality of symbols representing the plurality of measurement operations, and arranged along the sub flow direction according to an order of execution of the plurality of measurement operations.

2. The charged particle beam apparatus (10) according to claim 1, wherein
the flow image (106) is displayed at the time of setting the measurement sequence and during execution of the measurement sequence.

3. The charged particle beam apparatus (10) according to any preceding claim, wherein
the charged particle beam apparatus is a scanning electron microscope (10), and
the plurality of symbols arranged along the sub flow direction include:
an imaging symbol representing a measurement operation to produce an electron microscope image by detecting electrons emitted from the sample; and
an analysis symbol representing a measurement operation to analyze the sample by detecting an X-ray emitted from the sample.

4. The charged particle beam apparatus (10) according to claim 3, wherein
the analysis symbol is one or both of a spectrum analysis symbol representing a measurement operation to produce an X-ray spectrum as an analysis result, or a map analysis symbol representing a measurement operation to produce an element map as an analysis result.

5. The charged particle beam apparatus (10) according to any preceding claim, wherein
the flow image (106) further includes a completion graphic (122) representing completion of the measurement sequence, and
the completion graphic (122) includes a display element (123) representing presence or absence of execution of a particular completion operation.

6. The charged particle beam apparatus (10) according to any preceding claim, further comprising:
an overhead image producer (44) that produces an overhead image including a plurality of marks representing a plurality of measurement regions which are set on the sample, and
the overhead image is displayed along with the flow image at least at the time of setting the measurement sequence.

7. The charged particle beam apparatus (10) according to claim 6, wherein
when a particular measurement region is selected from among the plurality of measurement regions, the overhead image producer (44) emphasizes a particular mark corresponding to the particular measurement region, and, at the same time, the flow image producer (46) emphasizes all or a part of a particular graphic corresponding to the particular measurement region, and
when a particular measurement step is selected from among the plurality of measurement steps, the flow image producer (46) emphasizes all or a part of a particular graphic corresponding to the particular measurement step, and, at the same time, the overhead image producer (44) emphasizes a particular mark corresponding to the particular measurement step.

8. The charged particle beam apparatus (10) according to any preceding claim, further comprising:
a report producer (48) that produces a plurality of reports corresponding to the plurality of measurement steps, wherein
the report producer (48) includes:
a function to produce a plurality of provisional reports as the plurality of reports; and
a function to produce a plurality of actual reports as the plurality of reports based on a result of execution of the plurality of measurement steps,
all or a part of the plurality of provisional reports are displayed at the time of setting the measurement sequence, and
all or a part of the plurality of actual reports are displayed after completion of the measurement sequence.

9. The charged particle beam apparatus (10) according to claim 8, wherein
a report which is being displayed changes from the provisional report to the actual report during execution of or at the completion of execution of each measurement step of the plurality of measurement steps.

10. The charged particle beam apparatus (10) according to any preceding claim, further comprising:
a storage (26) that stores a plurality of measurement condition sets for executing the plurality of measurement steps, wherein
each of the plurality of measurement condition sets includes a common measurement condition, and one or a plurality of individual measurement conditions, and
an image for setting a measurement condition is displayed along with the flow image at least at the time of setting the measurement sequence.

11. An image production method of producing a flow image (106), wherein
the flow image (106) is an image representing a measurement sequence including a plurality of measurement steps which are sequentially executed by a charged particle beam apparatus (10), and which is displayed at the time of setting the measurement sequence and during execution of the measurement sequence,
the flow image (106) has a main flow direction and a sub flow direction which are orthogonal to each other,
the flow image (106) includes a plurality of graphics (120, 122) representing the plurality of measurement steps, and arranged along the main flow direction according to an order of execution of the plurality of measurement steps,
the plurality of graphics (120) include at least one multi-graphic representing a multi-measurement step including a plurality of measurement operations, and
each of the at least one multi-graphic includes a plurality of symbols representing the plurality of measurement operations, and arranged along the sub flow direction according to an order of execution of the plurality of measurement operations.

12. A program which is executed by an information processing apparatus (14), to produce a flow image (106), wherein
the flow image (106) is an image representing a measurement sequence including a plurality of measurement steps which are sequentially executed by a charged particle beam apparatus (10), and which is displayed at the time of setting the measurement sequence and during execution of the measurement sequence,
the flow image (106) has a main flow direction and a sub flow direction which are orthogonal to each other,
the flow image (106) includes a plurality of graphics (120, 122) representing the plurality of measurement steps, and arranged along the main flow direction according to an order of execution of the plurality of measurement steps,
the plurality of graphics (120) include at least one multi-graphic representing a multi-measurement step including a plurality of measurement operations, and
each of the at least one multi-graphic includes a plurality of symbols representing the plurality of measurement operations, and arranged along the sub flow direction according to an order of execution of the plurality of measurement operations.
